# EUROPÄISCHE PATENTSCHRIFT

(11) **EP 3 971 311 B1**
(45) Veröffentlichungstag und Bekanntmachung des Hinweises auf die Patenterteilung: **06.07.2022**
(21) Anmeldenummer: 20196582.9
(22) Anmeldetag: 17.09.2020
(51) Int. Cl.: C22C 1/04, C22C 1/10, C22C 5/04

(54) **VERBESSERTE, DISPERSIONSGEHÄRTETE EDELMETALLLEGIERUNG**
IMPROVED DISPERSION-HARDENED PRECIOUS METAL ALLOY
ALLIAGE DE MÉTAUX PRÉCIEUX DURCI PAR DISPERSION AMÉLIORÉ

(43) Veröffentlichungstag der Anmeldung: 23.03.2022
(73) Patentinhaber: Heraeus Deutschland GmbH & Co. KG, 63450 Hanau (DE)
(72) Erfinder: WEGNER, Matthias, 63450 Hanau (DE)
(74) Vertreter: Schultheiss & Sterzel Patentanwälte PartG mbB

(56) Entgegenhaltungen:
- EP-A1- 1 964 938
- WO-A1-2015/082630
- CN-A- 106 111 725
- CN-B- 108 149 055

## Beschreibung

Die Erfindung betrifft eine Platin-Zusammensetzung sowie einen Tiegel zur Kristallzucht, ein Halbzeug, ein Werkzeug, ein Rohr, einen Rührer, eine Glasfaserdüse oder ein Bauteil zur Glasherstellung oder Glasbearbeitung aus einer solchen Platin-Zusammensetzung sowie ein Verfahren zur schmelzmetallurgischen Herstellung einer solchen Platin-Zusammensetzung. Die Platin-Zusammensetzung besteht dabei zumindest zu 70 Gew% aus Platin (Pt) und enthält Oxide der Nicht-Edelmetalle Zirkonium (Zr), Yttrium (Y) und Scandium (Sc).

Formkörper aus Platin werden vielfach in Hochtemperaturprozessen eingesetzt, bei denen das Material eine hohe Korrosionsbeständigkeit aufweisen muss. Beispielsweise werden Bauteile aus Platin in der Glasindustrie verwendet, die mechanisch belastet sind, wie zum Beispiel Rührer oder Glasfaserdüsenwannen. Nachteilig an Platin als Werkstoff ist jedoch dessen geringe mechanische Festigkeit bei hohen Temperaturen. Daher werden im Allgemeinen für die zuvor genannten Hochtemperaturprozesse dispersionsgehärtete Platin-Zusammensetzungen eingesetzt. Dispersionsgehärtete Platin-Zusammensetzungen werden folglich insbesondere in der Spezialglas- und Glasfaserindustrie eingesetzt, finden aber außerdem in der Kristallzucht Anwendung.

Die Herstellung, Bearbeitung und die physikalischen Eigenschaften derartiger dispersionsgehärteter Platin-Zusammensetzungen sind beispielsweise aus den Druckschriften GB 1 280 815 A, GB 1 340 076 A, GB 2 082 205 A, EP 0 683 240 A2, EP 0 870 844 A1, EP 0 947 595 A2, EP 1 188 844 A1, EP 1 295 953 A1, EP 1 964 938 A1, US 2 636 819 A, US 4 507 156 A, DE 23 55 122 A1, WO 81/01013 A1 und WO 2015/082630 A1 bekannt.

Dispersionsverfestigte Platin-Zusammensetzungen werden meistens pulvermetallurgisch oder schmelzmetallurgisch durch Zulegieren von Zirkonium (Zr) und gegebenenfalls weiteren Nicht-Edelmetallen wie Yttrium (Y) oder Scandium (Sc) hergestellt, welche in einem nachgelagerten Oxidationsprozess zu Zirkonoxid (ZrO₂), Yttriumoxid (Y₂O₃) und Scandiumoxid (Sc₂O₃) oxidiert werden.

Die Herstellung von dispersionsverfestigten Legierungen ist ein komplexer und zeitaufwendiger Prozess. Die Oxidationszeit wird dafür benötigt, Dispersoide in dem aus der Schmelze gewonnenen kompakten Volumenkörper (vergleiche hierzu beispielsweise die WO 2015/082630 A1) durch innere Oxidation zu bilden, indem Sauerstoff in den Volumenkörper eindiffundiert.

Die Aufgabe der Erfindung besteht also darin, die Nachteile des Stands der Technik zu überwinden. Insbesondere sollen eine Platin-Zusammensetzung und daraus hergestellte Bauteile bereitgestellt werden, die kostengünstig und unaufwendig hergestellt werden können. Gleichzeitig sollen die Platin-Zusammensetzung und die daraus hergestellten Bauteile eine möglichst große Zeitstandsfestigkeit bei hohen Temperaturen aufweisen. Dadurch können die Platin-Zusammensetzung und die daraus hergestellten Bauteile bei hohen Temperaturen unter mechanischer Belastung eingesetzt werden.

Durch die Erfindung sollen sowohl die mechanischen Eigenschaften verbessert als auch die Prozesskosten abgesenkt werden. Allgemein sind derartige Platin-Zusammensetzungen vor allem bei hohen Anwendungstemperaturen unter korrosiven Bedingungen in Kombination mit signifikanter mechanischer Belastung im Einsatz, wie beispielsweise als Rührer oder andere Werkzeuge und Bauteile, als Glasfaserdüsen oder als Tiegel für Glasschmelzen.

Die Aufgaben der Erfindung werden gelöst durch eine dispersionsgehärtete Platin-Zusammensetzung mit zumindest 70 Gew% Platin, die Platin-Zusammensetzung enthaltend bis zu 29,95 Gew% von einem der Metalle Rhodium, Gold, Iridium und Palladium oder von einer Mischung von wenigstens zwei der Metalle Rhodium, Gold, Iridium und Palladium, die Platin-Zusammensetzung enthaltend zwischen 0,05 Gew% und 1 Gew% Oxide der Nicht-Edelmetalle Zirkonium, Yttrium und Scandium und die Platin-Zusammensetzung enthaltend als Rest das Platin einschließlich Verunreinigungen, wobei zwischen 7,0 mol% und 11,0 mol% der Oxide der Nicht-Edelmetalle Yttriumoxid ist, zwischen 0,1 mol% und 5,0 mol% der Oxide Scandiumoxid ist und der Rest der Oxide Zirkonoxid einschließlich oxidischer Verunreinigungen ist.

Die Platin-Zusammensetzung ist vorzugsweise eine Platin-Basis-Legierung. Unter einer Platin-Basis-Legierung wird eine Legierung verstanden, die zumindest zu 50 Atom% aus Platin besteht.

Bevorzugt sind 0,1 Gew% bis 0,7 Gew%, besonders bevorzugt 0,15 Gew% bis 0,6 Gew% und speziell bevorzugt 0,2 Gew% bis 0,5 Gew% der Oxide der Nicht-Edelmetalle in der dispersionsgehärteten Platinzusammensetzung enthalten. Hohe Anteile an Nicht-Edelmetalloxiden führen zu höheren Standzeiten von aus der Platin-Zusammensetzung gefertigten Volumenkörpern bei mechanischer Belastung. Volumenkörper mit geringen Anteilen an Nicht-Edelmetalloxiden zeigen Vorteile hinsichtlich der Verarbeitbarkeit, beispielsweise Schweißbarkeit oder Formbarkeit der Volumenkörper. Der Begriff Volumenkörper ist hierbei umfassend zu verstehen. Bevorzugt kann ein Volumenkörper beispielsweise in Form eines Blechs, eines Rohrs oder eines Drahts ausgestaltet sein.

Die erfindungsgemäße dispersionsgehärtete Platin-Zusammensetzung umfasst zumindest 70 Gew% Platin und bis zu 29,95 Gew% von wenigstens einem der Metalle Rhodium, Gold, Iridium und Palladium. Demgemäß kann die Zusammensetzung im Wesentlichen aus Platin und den zuvor dargelegten Oxiden der Nicht-Edelmetalle Zirkonium, Yttrium und Scandium bestehen. Es kann sich bei der Platin-Zusammensetzung also um bis auf übliche beziehungsweise herstellungsbedingte Verunreinigungen reines Platin handeln, in dem die Oxide der Nicht-Edelmetalle Zirkonium, Yttrium und Scandium verteilt sind. Weiterhin kann die Platinzusammensetzung aber auch weitere Edelmetalle, nämlich Rhodium, Gold, Iridium und Palladium, umfassen, wobei die Platinzusammensetzung in diesem Fall eine Platin-Basis-Legierung ist.

Unter den Verunreinigungen der Edelmetalle und der Nicht-Edelmetalle beziehungsweise Oxide sind übliche Verunreinigungen zu verstehen, die aufgrund und im Zuge des Darstellungsprozesses in die Ausgangsmaterialien gelangt sind beziehungsweise nicht mit vertretbarem Aufwand (vollständig) aus den Rohstoffen entfernt werden konnten.

Es kann vorgesehen sein, dass die Oxide der Nicht-Edelmetalle Zirkonium, Yttrium und Scandium zumindest zu 70 % vollständig oxidiert vorliegen, bevorzugt zumindest zu 90 % oxidiert vorliegen und besonders bevorzugt vollständig oxidiert vorliegen.

Hierdurch wird eine besonders stark gehärtete Platin-Zusammensetzung erzielt.

Bevorzugt sind die Nicht-Edelmetalle zu wenigstens 70%, besonders bevorzugt zu wenigstens 90% mit Sauerstoff oxidiert. Hierbei werden alle Oxidationsstufen der Nicht- Edelmetalle berücksichtigt, sodass vorzugsweise höchstens 30%, besonders bevorzugt höchstens 10% der Nicht-Edelmetalle als Metall, das heißt in der formalen Oxidationsstufe 0 vorliegen.

Ferner kann vorgesehen sein, dass die Verunreinigungen in der Summe einen Anteil von maximal 1 Gew% in der Platin-Zusammensetzung haben, bevorzugt von maximal 0,5 Gew%.

Hierdurch wird sichergestellt, dass die physikalischen Eigenschaften der Platin-Zusammensetzung nicht oder möglichst wenig von den Verunreinigungen beeinflusst werden.

Auch kann vorgesehen sein, dass die Oxide der Nicht-Edelmetalle zu wenigstens 50 mol% als mit Yttriumoxid und/oder Scandiumoxid kubisch stabilisiertes Zirkonoxid vorliegen, bevorzugt die Oxide der Nicht-Edelmetalle zu wenigstens 80 mol% als mit Yttriumoxid und/oder Scandiumoxid kubisch stabilisiertes Zirkonoxid vorliegen.

Es wurde gefunden, dass die Sauerstoff-Diffusivität entlang der Oxide durch diese Maßnahmen gesteigert werden kann. Hierdurch wird eine hohe Sauerstoff-Diffusivität durch die oxidischen Bereiche und damit eine gute Oxidierbarkeit der Nicht-Edelmetalle Zirkonium, Yttrium und Scandium in der Platin-Zusammensetzung erreicht. Dadurch lässt sich die Platin-Zusammensetzung in besonders kurzer Zeit durch oxidische Ausscheidungen härten.

Bevorzugt kann vorgesehen sein, dass die Platin-Zusammensetzung nicht pulvermetallurgisch hergestellt ist.

Des Weiteren kann vorgesehen sein, dass die Platin-Zusammensetzung schmelzmetallurgisch hergestellt ist, anschließend ausgewalzt und durch eine Temperaturbehandlung in einem oxidierenden Medium oxidiert ist, so dass die in der Platin-Zusammensetzung enthaltenen Nicht-Edelmetalle vollständig oxidiert sind.

Hierdurch wird eine besonders gut gehärtete Platin-Zusammensetzung erreicht.

Gemäß einer bevorzugten Weiterbildung kann vorgesehen sein, dass das Verhältnis von Yttriumoxid zu Scandiumoxid in der Platin-Zusammensetzung in einem Bereich von 2,6:1 bis 10:1 liegt.

In diesem Bereich hat sich überraschend eine besonders kurze notwendige Zeit zur Bildung der Ausscheidungen durch Oxidation der Nicht-Edelmetalle Zirkonium, Yttrium und Scandium ergeben.

Ein Verhältnis (beziehungsweise Mischungsverhältnis) von Yttriumoxid zu Scandiumoxid von mindestens 2,6:1 und maximal 10:1 bedeutet, dass die Anzahl der Mole beziehungsweise Moleküle von Yttriumoxid in den der Platin-Zusammensetzung mindestens 2,6-mal größer ist als die Anzahl der Mole beziehungsweise Moleküle des Scandiumoxids in den Oxiden der Nicht-Edelmetalle der Platin-Zusammensetzung und maximal 10-mal größer ist, als die Anzahl der Mole beziehungsweise Moleküle des Scandiumoxids in den Oxiden der Nicht-Edelmetalle der Platin-Zusammensetzung.

Des Weiteren kann vorgesehen sein, dass zwischen 8,0 und 10,0 mol% der Oxide Yttriumoxid ist.

In diesem Zusammensetzungsbereich kann das Material schneller oxidiert werden, als in den angrenzenden Zusammensetzungsbereichen mit etwas mehr oder weniger Yttriumoxid.

Ferner kann vorgesehen sein, dass die Platin-Zusammensetzung zumindest 80 Gew% Platin einschließlich Verunreinigungen enthält, wobei vorzugsweise die Platin-Zusammensetzung bis zu 10 Gew% Gold oder bis zu 19,95 Gew% Rhodium enthält.

Durch den höheren Platingehalt ist die Platin-Zusammensetzung kostengünstiger zu fertigen.

Des Weiteren kann vorgesehen sein, dass die Platin-Zusammensetzung zumindest 1 Gew% Rhodium, Gold, Palladium oder Iridium enthält, wobei vorzugsweise die Platin-Zusammensetzung zumindest 5 Gew% Rhodium und/oder zumindest 3 Gew% Gold enthält.

Hierdurch kann eine größere Härte der Platin-Zusammensetzung erreicht werden und die mechanischen Eigenschaften können an bestimmte Anforderungen angepasst werden. Gold beeinflusst außerdem die Benetzungseigenschaften der Platin-Zusammensetzung mit einer Glasschmelze positiv.

Es kann auch vorgesehen sein, dass die Platin-Zusammensetzung zwischen 5 Gew% und 20 Gew% Rhodium enthält und bis auf Verunreinigungen kein Gold, Iridium oder Palladium, oder die Platin-Zusammensetzung zwischen 2 Gew% und 10 Gew% Gold enthält und bis auf Verunreinigungen kein Rhodium, Iridium oder Palladium.

Diese Platin-Zusammensetzungen sind für Hochtemperaturanwendungen aufgrund ihrer mechanischen und chemischen Stabilität besonders gut geeignet.

Des Weiteren kann vorgesehen sein, dass die Platin-Zusammensetzung aus 10 Gew% Rhodium, den Oxiden der Nicht-Edelmetalle Zirkonium, Yttrium und Scandium und als Rest Platin einschließlich Verunreinigungen besteht oder die Platin-Zusammensetzung aus 5 Gew% Gold, den Oxiden der Nicht-Edelmetalle Zirkonium, Yttrium und Scandium und als Rest Platin einschließlich Verunreinigungen besteht.

Diese Platin-Zusammensetzungen sind für Hochtemperaturanwendungen aufgrund ihrer mechanischen und chemischen Stabilität besonders gut geeignet.

Ferner kann vorgesehen sein, dass die Platin-Zusammensetzung eine Zeitstandfestigkeit von zumindest 500 h bei 1400 °C unter einer Last von 20 MPa aufweist.

Platin-Zusammensetzungen mit diesen physikalischen Eigenschaften sind durch die Oxidation der Nicht-Edelmetalle Zirkonium, Yttrium und Scandium herstellbar.

Die der vorliegenden Erfindung zugrundeliegenden Aufgaben werden auch gelöst durch einen Tiegel zur Kristallzucht, ein Halbzeug, ein Werkzeug, ein Rohr, einen Rührer, eine Glasfaserdüse oder ein Bauteil zur Glasherstellung oder Glasbearbeitung bestehend aus oder aufweisend eine Platin-Zusammensetzung nach einem der vorangehenden Ansprüche oder Temperatursensor aufweisend eine Platin-Zusammensetzung nach einem der vorangehenden Ansprüche.

Tiegel, Halbzeuge, Glasfaserdüsen, Rührer, Rohre, Temperatursensoren, Werkzeuge oder Bauteile zur Glasherstellung oder Glasbearbeitung aus oder mit einer solchen Platin-Zusammensetzungen sind aufgrund ihrer chemischen Hochtemperaturbeständigkeit und mechanischen Festigkeit besonders gut zur Lagerung, Leitung und Bearbeitung von und dem Kontakt mit Glasschmelzen geeignet.

Die der vorliegenden Erfindung zugrundeliegenden Aufgaben werden ferner gelöst durch ein Verfahren zur Herstellung einer Platin-Zusammensetzung mit den folgenden chronologischen Schritten:
A) Herstellen einer Schmelze aufweisend zumindest 70 Gew% Platin, bis zu 29,95 Gew% eines der Metalle Rhodium, Gold, Iridium und Palladium oder einer Mischung von wenigstens zwei der Metalle Rhodium, Gold, Iridium und Palladium, zwischen 0,05 Gew% und 1 Gew% oxidierbare Nicht-Edelmetalle in Form von Zirkonium, Yttrium und Scandium und als Rest Platin einschließlich Verunreinigungen, wobei das Verhältnis von Zirkonium zu Yttrium in der Schmelze in einem Bereich von 5,9:1 bis 4,3:1 liegt und das Verhältnis von Zirkonium zu Scandium in der Schmelze mindestens 17,5:1 beträgt.
B) Erstarren der Schmelze zu einem Festkörper,
C) Verarbeiten des Festkörpers zu einem Volumenkörper; und
D) Oxidation der in dem Volumenkörper enthaltenen Nicht-Edelmetalle durch eine Wärmebehandlung in oxidierendem Medium über einen Zeitraum von wenigstens 48 h bei einer Temperatur von zumindest 750°C.

Beim Verarbeiten des Festkörpers zu einem Volumenkörper findet eine Umformung des Festkörpers statt und es wird eine gewünschte Volumenform gezielt erzeugt.

Die Oxidationszeit hängt aufgrund der mittleren Diffusionslänge des Sauerstoffs von der Stärke des zu oxidierenden Materials ab. Je größer die Materialstärke, desto länger die notwendige Oxidationszeit. Die 48 h beziehen sich auf ein Blech mit einer Stärke von 0,5 mm. Bei dickeren Blechen erhöht sich die Oxidationszeit. Analog führt eine Erhöhung der Temperatur zu einer Verkürzung der Oxidationszeit.

Bei erfindungsgemäßen Verfahren kann vorgesehen sein, dass mit dem Verfahren eine erfindungsgemäße beziehungsweise zuvor beschriebene Platin-Zusammensetzung hergestellt wird.

Das Verfahren weist dann die zu den Platin-Zusammensetzungen aufgeführten Vorteile auf.

Des Weiteren kann vorgesehen sein, dass bei der Oxidation in Schritt D) der Sauerstoff durch den Festkörper diffundiert und durch Yttriumoxid und/oder Scandiumoxid kubisch stabilisiertes Zirkonoxid mittels Sauerstoffionenleitung transportiert wird.

Hierdurch wird eine besonders schnelle Oxidation der Nicht-Edelmetalle Zirkonium, Yttrium und Scandium und damit eine besonders schnelle Härtung der Platin-Zusammensetzung erreicht.

Auch kann vorgesehen sein, dass bei der Oxidation in Schritt D) eine Dispersionshärtung durch aus der Metallmatrix des Festkörpers ausgeschiedene Yttriumoxid-stabilisierte und/oder Scandiumoxid-stabilisierte Zirkonoxid-Partikel erfolgt.

Hiermit wird die Platin-Zusammensetzung relativ schnell (im Vergleich zum Stand der Technik) in einer vorteilhaften Form und bei dichtem Festkörper gehärtet.

Der Erfindung liegt die überraschende Erkenntnis zugrunde, dass die erfindungsgemäßen Platin-Zusammensetzungen wesentlich schneller und damit kostengünstiger herzustellen sind, als die im Stand der Technik mit vergleichbaren Verfahren hergestellten Platin-Zusammensetzungen. Gleichzeitig werden die mechanischen Hochtemperatureigenschaften der Platin-Zusammensetzung weiter verbessert, insbesondere hinsichtlich der Hochtemperatur-Zeitstandsfestigkeit. Es hat sich im Rahmen der vorliegenden Erfindung gezeigt, dass die beanspruchte Zusammensetzung überraschend eine besonders schnelle Oxidierbarkeit und damit eine besonders schnelle Bildung von Dispersoiden in der Platin-Zusammensetzung ermöglicht. Dass dieser Befund überraschend ist zeigt sich auch daran, dass im Rahmen der vorliegenden Erfindung untersuchte andere Oxide von Nichtedelmetallen zur Stabilisierung des Zirkonoxides wie zum Beispiel eine Kombination aus Scandium und Niob eine Verschlechterung der Oxidationszeit bewirkt haben, obwohl ein durch eine derartige Kombination stabilisiertes Zirkonoxid eine besonders hohe Stabilität und Sauerstoffdiffusivität aufzeigt.

Es wurde im Rahmen der vorliegenden Erfindung gefunden, dass durch die Verwendung von Zirkonium, Yttrium und Scandium in den angegebenen Mengenverhältnissen als Oxidbildner die Prozesszeiten verkürzt werden können, wodurch die Prozesskosten abgesenkt werden.

Durch die Erfindung ist es gelungen die Oxidationszeit (zur Bildung der Dispersoide) im Vergleich zum Stand der Technik um mehr als 25% zu reduzieren (im Vergleich zum Stand der Technik, wie beispielsweise im Vergleich zu den nach der WO 2015/082630 A1 hergestellten PtRh10-Legierungen). Gleichzeitig ergibt sich eine Verbesserung der Hochtemperatureigenschaften (insbesondere der Zeitstandsfestigkeit und der Kriechfestigkeit) im Vergleich zur WO 2015/082630 A1 (siehe dort Tabelle 1) mit einer erfindungsgemäßen Platin-Zusammensetzung eine Zeitstandsfestigkeit von über 1000 Stunden bei einer mechanischen Belastung von 9 MPa erreichbar ist, beziehungsweise die gleiche Zeitstandfestigkeit wie im Beispiel 1 der WO 2015/082630 A1 bei einer Last von 20 MPa erreicht wird, für eine dispersionsverfestigte PtRh10-Legierung bei 1600°C. Das Konzept ist ebenfalls auf andere dispersionsverfestigte Legierungen übertragbar, wobei ein vergleichbarer Mehrwert erwartbar ist.

Der Oxidationsprozess, in welchem das zunächst in der Platin-Matrix beziehungsweise in der Edelmetall-Matrix gelöste Zirkonium, Yttrium und Scandium oxidiert wird, hängt von zahlreichen Faktoren ab, unter anderem von der Temperatur beziehungsweise dem Diffusionskoeffizient (es handelt sich um einen thermisch aktivierten, diffusionskontrollierten Prozess), von der Sauerstofflöslichkeit im Matrixmaterial, vom Sauerstoffpartialdruck, von der Oxidbildnerkonzentration, von der Zusammensetzung des sich bildenden Oxids und von der Grenzfläche zwischen Oxid und Metallmatrix. Durch die Zusammensetzung der Oxide wird die lonenleitfähigkeit beeinflusst. Eine hohe lonenleitfähigkeit kann den Oxidationsprozess beschleunigen, ist jedoch nur einer von vielen Parametern, die zu einer Verbesserung der Oxidierbarkeit führen kann.

Durch eine Optimierung der molaren Zusammensetzung (Molverhältnis) der Oxidbildner (das heißt der Nicht-Edelmetalle) ist es im Rahmen der vorliegenden Erfindung gelungen, die Oxidationszeit in dem Festkörper zu verringern, bei gleichzeitiger Verbesserung der Hochtemperatureigenschaften, letzteres zusätzlich auch durch eine leichte Erhöhung der Gesamtmenge an Oxidbildnern.

Im Folgenden werden Ausführungsbeispiele der Erfindung erläutert, ohne jedoch dabei die Erfindung zu beschränken.

Die nachfolgend beschriebenen Platin-Zusammensetzungen wurden hergestellt, indem ein Barren mit einem Gewicht von 10 kg mit Vakuum-Induktionsschmelzen aus der Schmelze abgegossen wurde (Ausführungsbeispiele 1-4). Zusätzlich wurden Ronden mit einem Gewicht von je 200 g durch Lichtbogenschmelzen hergestellt (Ausführungsbeispiele 5-9). Auf diese Weise wurden unterschiedliche Platin-Zusammensetzungen enthaltend 10 Gew% Rhodium hergestellt. Die Nicht-Edelmetalle Zirkonium, Yttrium und Scandium wurden während des Schmelzverfahrens hinzugefügt. Über Walzen und Tempern wurde ein 3 mm oder ein 2 mm starkes Blech der Platinzusammensetzung hergestellt. Das so hergestellte Blech wurde anschließend einer Oxidationsglühung unterzogen, um die Nicht-Edelmetalle zu oxidieren. Diese Art der Prozessierung ist in der WO 2015/082630 A1 (im Beispiel Halbzeugvorstufe 3) angegeben. Nachfolgend wurde das Blech einer thermomechanischen Prozessierung unterzogen. Die thermomechanische Prozessierung ist in der WO 2015/082630 A1 (wie von den Ansprüchen umfasst) beschrieben.

Die mechanischen Hochtemperatureigenschaften wurden anschließend experimentell bestimmt. Hierzu wurde die Zeitstandsfestigkeit mittels Kriechversuchen bei unterschiedlichen Belastungszuständen getestet.

Der Versuchsaufbau orientiert sich an der DIN EN ISO 204. Abweichungen von der Norm ergeben sich aus den hohen Prüftemperaturen, für welche in der Norm keine Vorgaben definiert sind. Die Probe wird als Widerstandsheizung geschaltet erhitzt und mit einer statischen, uniaxialen Last beladen. Die Temperatur wird mittels eines Pyrometers gemessen und die resultierende, zeitabhängige Dehnung mittels eines optischen Extensometers bestimmt.

Der Oxidationsgrad einer Legierung lässt sich durch Ermittlung des Sauerstoffgehaltes bestimmen. Der Sauerstoffgehalt der Legierung wird durch quantitative IR-Spektroskopie mit einem Gerät der Firma LECO (ONH836) bestimmt. Eine definierte Probenmenge wird in einem Graphittiegel aufgeschmolzen. Der in dem Material vorhandene Sauerstoff reagiert mit dem Kohlenstoff des Graphittiegels unter Bildung von CO/CO₂. Die freigesetzten Gase werden von einem Inertgas aus dem Ofen und durch einen Massendurchflussregler gespült. In einem weiteren Schritt wird vorhandenes CO zu CO₂ oxidiert. Der vorhandene Sauerstoff wird anschließend unter Verwendung eines NDIR-Sensors spektroskopisch als CO₂ identifiziert. Bei Kenntnis der chemischen Zusammensetzung der Legierung, lässt sich dann aus dem gemessenen Sauerstoff der Oxidationsgrad errechnen.

### Vergleichsbeispiel 1

10 Gew% Rhodium, 1830 ppm Zirkonium, 295 ppm Yttrium, 50 ppm Scandium und dem Rest Platin einschließlich üblicher Verunreinigungen.

Dies entspricht einem Stoffmengenanteil des Oxids des Nicht-Edelmetalls im oxidierten Zustand der Platin-Zusammensetzung von 7,5 mol% Y₂O₃ (Yttriumoxid), 2,5 mol% Sc₂O₃ (Scandiumoxid) und dem Rest ZrO₂ (Zirkonoxid).

Die Oxidation der Nicht-Edelmetalle des 3 mm starken Blechs erfolgte an Luft bei 900°C. Nach einer Oxidationszeit von 27 Tagen waren >90% der Nicht-Edelmetalle in dem Blech oxidiert. Im Anschluss wurde das Blech bei 1400°C für 6h duktilitätsgeglüht und wie in WO 2015/082630 A1 offenbart thermomechanisch prozessiert. Daraus resultierend ergibt sich eine Zeitstandsfestigkeit bei 1400°C und 20 MPa von 3 Stunden und bei 1600°C und 9 MPa von 50 Stunden.

### Vergleichsbeispiel 2

10 Gew% Rhodium, 1830 ppm Zirkonium, 295 ppm Yttrium, 50 ppm Scandium und dem Rest Platin einschließlich üblicher Verunreinigungen.

Dies entspricht einem Stoffmengenanteil des Oxids des Nicht-Edelmetalls im oxidierten Zustand der Platin-Zusammensetzung von 7,5 mol% Y₂O₃ (Yttriumoxid), 2,5 mol% Sc₂O₃ (Scandiumoxid) und dem Rest ZrO₂ (Zirkonoxid).

Die Oxidation der Nicht-Edelmetalle des 3 mm starken Blechs erfolgte an Luft bei 1000°C. Nach einer Oxidationszeit von 9 Tagen waren >90% der Nicht-Edelmetalle in dem Blech oxidiert. Im Anschluss wurde das Blech bei 1400°C für 6h duktilitätsgeglüht und das Blech wie in WO 2015/082630 A1 offenbart thermomechanisch prozessiert. Daraus resultierend ergibt sich eine Zeitstandsfestigkeit bei 1400°C und 20 MPa von 0,5 Stunden und bei 1600°C und 9 MPa von 3 Stunden.

### Beispiel 3 (Erfindung)

10 Gew% Rhodium, 2770 ppm Zirkonium, 546 ppm Yttrium, 63 ppm Scandium und dem Rest Platin einschließlich üblicher Verunreinigungen.

Dies entspricht einem Stoffmengenanteil des Oxids des Nicht-Edelmetalls im oxidierten Zustand der Platin-Zusammensetzung von 9,0 mol% Y₂O₃ (Yttriumoxid), 2,0 mol% Sc₂O₃ (Scandiumoxid) und dem Rest ZrO₂ (Zirkonoxid).

Die Oxidation der Nicht-Edelmetalle des 3 mm starken Blechs erfolgte an Luft bei 900°C. Nach einer Oxidationszeit von nur 19 Tagen waren >90% der Nicht-Edelmetalle in dem Blech oxidiert. Im Anschluss wurde das Blech bei 1400°C für 6h duktilitätsgeglüht und das Blech wie in WO 2015/082630 A1 offenbart thermomechanisch prozessiert. Daraus resultierend ergibt sich eine Zeitstandsfestigkeit bei 1400°C und 20 MPa von mehr als 500 Stunden und bei 1600°C und 9 MPa von mehr als 1000 Stunden.

### Beispiel 4 (Erfindung)

10 Gew% Rhodium, 2770 ppm Zirkonium, 546 ppm Yttrium, 63 ppm Scandium und dem Rest Platin einschließlich üblicher Verunreinigungen.

Dies entspricht einem Stoffmengenanteil des Oxids des Nicht-Edelmetalls im oxidierten Zustand der Platin-Zusammensetzung von 9,0 mol% Y₂O₃ (Yttriumoxid), 2,0 mol% Sc₂O₃ (Scandiumoxid) und dem Rest ZrO₂ (Zirkonoxid).

Die Oxidation der Nicht-Edelmetalle des 3 mm starken Blechs erfolgte an Luft bei 1000°C. Nach einer Oxidationszeit von nur 6 Tagen waren >90% der Nicht-Edelmetalle in dem Blech oxidiert.

Durch eine Optimierung der molaren Zusammensetzung, also der Molverhältnisse der oxidbildenden Nicht-Edelmetalle und durch eine Erhöhung der Gesamtmenge an oxidbildenden Nicht-Edelmetallen (von 2150 ppm auf 3400 ppm) ist es folglich gelungen die Oxidationszeit in dem Festkörper um >25% zu verringern, bei gleichzeitiger Verbesserung der Hochtemperatureigenschaften.

### Beispiel 5 (Erfindung)

10 Gew% Rhodium, 2710 ppm Zirkonium, 511 ppm Yttrium, 65 ppm Scandium und dem Rest Platin einschließlich Verunreinigungen. Eine Ronde von 200 g wurde mittels Lichtbogenschmelzen hergestellt.

Dies entspricht einem Stoffmengenanteil des Oxids des Nicht-Edelmetalls im oxidierten Zustand der Platin-Zusammensetzung von 8,6 mol% Y₂O₃ (Yttriumoxid), 2,2 mol% Sc₂O₃ (Scandiumoxid) und dem Rest ZrO₂ (Zirkonoxid).

Die Oxidation der Nicht-Edelmetalle des 2 mm starken Blechs erfolgte an Luft bei 900°C. Nach einer Oxidationszeit von nur 10 Tagen waren >90% der Nicht-Edelmetalle in dem Blech oxidiert. Im Anschluss wurde das Blech bei 1400°C für 6h duktilitätsgeglüht und das Blech wie in WO 2015/082630 A1 offenbart thermomechanisch prozessiert. Daraus resultierend ergibt sich eine Zeitstandsfestigkeit bei 1400°C und 20 MPa von mehr als 500 Stunden und bei 1600°C und 9 MPa von mehr als 1000 Stunden.

### Vergleichsbeispiel 6

10 Gew% Rhodium, 1870 ppm Zirkonium, 313 ppm Yttrium, 33 ppm Scandium und dem Rest Platin einschließlich üblicher Verunreinigungen. Eine Ronde von 200 g wurde mittels Lichtbogenschmelzen hergestellt.

Dies entspricht einem Stoffmengenanteil des Oxids des Nicht-Edelmetalls im oxidierten Zustand der Platin-Zusammensetzung von 7,8 mol% Y₂O₃ (Yttriumoxid), 1,6 mol% Sc₂O₃ (Scandiumoxid) und dem Rest ZrO₂ (Zirkonoxid).

Die Oxidation der Nicht-Edelmetalle eines 2 mm starken Blechs erfolgte an Luft bei 900°C. Nach einer Oxidationszeit von 20 Tagen waren >90% der Nicht-Edelmetalle in dem Blech oxidiert. Im Anschluss wurde das Blech bei 1400°C für 6h duktilitätsgeglüht und das Blech wie in WO 2015/082630 A1 offenbart thermomechanisch prozessiert. Es ergibt sich eine Zeitstandsfestigkeit analog Vergleichsbeispiel 1.

Zum weiteren Vergleich wurden drei weitere Vergleichsversuche durchgeführt, bei denen eine Kombination aus Scandiumoxid und Nioboxid (Nb₂O₅) anstelle von Yttriumoxid und Scandiumoxid zur Stabilisierung der Sauerstoffionen-leitenden kubischen Zirkonoxid-Phase in die Platin-Zusammensetzung eingebracht wurde.

Die nachfolgend beschriebenen Platin-Zusammensetzungen wurden hergestellt, indem Ronden mit Einzelgewichten von je 200 g durch Lichtbogenschmelzen hergestellt wurden. Auf diese Weise wurden 3 unterschiedliche Platin-Zusammensetzungen enthaltend 10 Gew% Rhodium, 200 ppm Scandium und variablen Anteilen von Niob hergestellt. Über Walzen und Tempern wurde ein 2 mm starkes Blech der Platinzusammensetzung hergestellt.

Der Anteil der oxidierten Nicht-Edelmetalle in der Platin-Zusammensetzung wurde anschließend mittels quantitativer IR-Spektroskopie bestimmt.

### Vergleichsbeispiel 7

10 Gew% Rhodium, 1800 ppm Zirkonium, 80 ppm Niob, 200 ppm Scandium und dem Rest Platin einschließlich üblicher Verunreinigungen.

Dies entspricht einem Stoffmengenanteil des Oxids des Nicht-Edelmetalls im oxidierten Zustand der Platin-Zusammensetzung von 2,0 mol% Nb₂O₅ (Nioboxid), 10,0 mol% Sc₂O₃ (Scandiumoxid) und dem Rest ZrO₂ (Zirkonoxid).

Die Oxidation der Nicht-Edelmetalle des 2 mm starken Blechs erfolgte an Luft bei 900°C. Nach einer Oxidationszeit von 20 Tagen waren lediglich 39% der Nicht-Edelmetalle in dem Blech oxidiert.

### Vergleichsbeispiel 8

10 Gew% Rhodium, 1800 ppm Zirkonium, 40 ppm Niob, 200 ppm Scandium und dem Rest Platin einschließlich üblicher Verunreinigungen.

Dies entspricht einem Stoffmengenanteil des Oxids des Nicht-Edelmetalls im oxidierten Zustand der Platin-Zusammensetzung von 1,0 mol% Nb₂O₅ (Nioboxid), 10,0 mol% Sc₂O₃ (Scandiumoxid) und dem Rest ZrO₂ (Zirkonoxid).

Die Oxidation der Nicht-Edelmetalle des 2 mm starken Blechs erfolgte an Luft bei 900°C. Nach einer Oxidationszeit von 20 Tagen waren lediglich 42% der Nicht-Edelmetalle in dem Blech oxidiert.

### Vergleichsbeispiel 9

10 Gew% Rhodium, 1800 ppm Zirkonium, 20 ppm Niob, 200 ppm Scandium und dem Rest Platin einschließlich üblicher Verunreinigungen.

Dies entspricht einem Stoffmengenanteil des Oxids des Nicht-Edelmetalls im oxidierten Zustand der Platin-Zusammensetzung von 0,5 mol% Nb₂O₅ (Nioboxid), 10,0 mol% Sc₂O₃ (Scandiumoxid) und dem Rest ZrO₂ (Zirkonoxid).

Die Oxidation der Nicht-Edelmetalle des 2 mm starken Blechs erfolgte an Luft bei 900°C. Nach einer Oxidationszeit von 20 Tagen waren lediglich 36% der Nicht-Edelmetalle in dem Blech oxidiert.

Die Oxidationszeit bei den Vergleichsbeispielen 6, 7 und 8 wurde also im Vergleich zum Vergleichsbeispiel 5 deutlich verschlechtert. Dies zeigt, dass kein unmittelbarer Rückschluss von der Sauerstoff-Ionenleitfähigkeit der Oxide auf die Oxidierbarkeit beziehungsweise auf die Oxidationszeit der Platin-Zusammensetzung geschlossen werden kann.

Die Messungen zeigen, dass es für die Platin-Zusammensetzung keinen einfachen Zusammenhang in der Art gibt, dass ein Oxid mit hoher lonenleitfähigkeit eine Beschleunigung des Oxidationsprozess bewirken würde. Dementsprechend hat die erfindungsgemäße Wahl von Nicht-Edelmetallen in der erfindungsgemäßen Platin-Zusammensetzung zu einem überraschenden Erfolg geführt.

Die in der voranstehenden Beschreibung, sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

## Patentansprüche

1. Dispersionsgehärtete Platin-Zusammensetzung mit zumindest 70 Gew% Platin, die Platin-Zusammensetzung enthaltend bis zu 29,95 Gew% von einem der Metalle Rhodium, Gold, Iridium und Palladium oder von einer Mischung von wenigstens zwei der Metalle Rhodium, Gold, Iridium und Palladium, die Platin-Zusammensetzung enthaltend zwischen 0,05 Gew% und 1 Gew% Oxide der Nicht-Edelmetalle Zirkonium, Yttrium und Scandium und die Platin-Zusammensetzung enthaltend als Rest das Platin einschließlich Verunreinigungen, wobei
zwischen 8,0 mol% und 10,0 mol% der Oxide der Nicht-Edelmetalle Yttriumoxid ist, zwischen 0,1 mol% und 5,0 mol% der Oxide Scandiumoxid ist und der Rest der Oxide Zirkonoxid einschließlich oxidischer Verunreinigungen ist.

2. Platin-Zusammensetzung nach Anspruch 1, **dadurch gekennzeichnet, dass** die Oxide der Nicht-Edelmetalle Zirkonium, Yttrium und Scandium zumindest zu 70 % vollständig oxidiert vorliegen, bevorzugt zumindest zu 90 % oxidiert vorliegen und besonders bevorzugt vollständig oxidiert vorliegen.

3. Platin-Zusammensetzung nach Anspruch 1 oder 2, **dadurch gekennzeichnet, dass**
die Verunreinigungen in der Summe einen Anteil von maximal 1 Gew% in der Platin-Zusammensetzung haben, bevorzugt von maximal 0,5 Gew%.

4. Platin-Zusammensetzung nach einem der vorangehenden Ansprüche, **dadurch gekennzeichnet, dass**
die Oxide der Nicht-Edelmetalle zu wenigstens 50 mol% als mit Yttriumoxid und/oder Scandiumoxid kubisch stabilisiertes Zirkonoxid vorliegen, bevorzugt die Oxide der Nicht-Edelmetalle zu wenigstens 80 mol% als mit Yttriumoxid und/oder Scandiumoxid kubisch stabilisiertes Zirkonoxid vorliegen.

5. Platin-Zusammensetzung nach einem der vorangehenden Ansprüche, **dadurch gekennzeichnet, dass**
die Platin-Zusammensetzung schmelzmetallurgisch hergestellt ist, anschließend ausgewalzt und durch eine Temperaturbehandlung in einem oxidierenden Medium oxidiert ist, so dass die in der Platin-Zusammensetzung enthaltenen Nicht-Edelmetalle vollständig oxidiert sind.

6. Platin-Zusammensetzung nach einem der vorangehenden Ansprüche, **dadurch gekennzeichnet, dass**
das Verhältnis von Yttriumoxid zu Scandiumoxid in der Platin-Zusammensetzung in einem Bereich von 2,6:1 bis 10:1 liegt.

7. Platin-Zusammensetzung nach einem der vorangehenden Ansprüche, **dadurch gekennzeichnet, dass**
zwischen 8,0 mol% und 10,0 mol% der Oxide Yttriumoxid ist, bevorzugt zwischen 8,5 mol% und 9,5 mol% der Oxide Yttriumoxid ist.

8. Platin-Zusammensetzung nach einem der vorangehenden Ansprüche, **dadurch gekennzeichnet, dass**
zwischen 1,0 mol% und 3,0 mol% der Oxide Scandiumoxid ist, bevorzugt zwischen 1,5 mol% und 2,5 mol% der Oxide Scandiumoxid ist.

9. Platin-Zusammensetzung nach einem der vorangehenden Ansprüche, **dadurch gekennzeichnet, dass**
die Platin-Zusammensetzung zumindest 80 Gew% Platin einschließlich Verunreinigungen enthält, wobei vorzugsweise die Platin-Zusammensetzung bis zu 10 Gew% Gold oder bis zu 19,95 Gew% Rhodium enthält, und/oder die Platin-Zusammensetzung zumindest 1 Gew% Rhodium, Gold, Palladium oder Iridium enthält, wobei vorzugsweise die Platin-Zusammensetzung zumindest 5 Gew% Rhodium und/oder zumindest 3 Gew% Gold enthält.

10. Platin-Zusammensetzung nach einem der vorangehenden Ansprüche, **dadurch gekennzeichnet, dass**
die Platin-Zusammensetzung zwischen 5 Gew% und 20 Gew% Rhodium enthält und bis auf Verunreinigungen kein Gold, Iridium oder Palladium, oder die Platin-Zusammensetzung zwischen 2 Gew% und 10 Gew% Gold enthält und bis auf Verunreinigungen kein Rhodium, Iridium oder Palladium,
wobei bevorzugt
die Platin-Zusammensetzung aus 10 Gew% Rhodium, den Oxiden der Nicht-Edelmetalle Zirkonium, Yttrium und Scandium und als Rest Platin einschließlich Verunreinigungen besteht, oder
die Platin-Zusammensetzung aus 5 Gew% Gold, den Oxiden der Nicht-Edelmetalle Zirkonium, Yttrium und Scandium und als Rest Platin einschließlich Verunreinigungen besteht.

11. Platin-Zusammensetzung nach einem der vorangehenden Ansprüche, **dadurch gekennzeichnet, dass**
die Platin-Zusammensetzung eine Zeitstandsfestigkeit von zumindest 500 h bei 1400 °C unter einer Last von 20 MPa aufweist.

12. Tiegel zur Kristallzucht, Halbzeug, Werkzeug, Rohr, Rührer, Glasfaserdüse oder Bauteil zur Glasherstellung oder Glasbearbeitung bestehend aus oder aufweisend eine Platin-Zusammensetzung nach einem der vorangehenden Ansprüche oder Temperatursensor aufweisend eine Platin-Zusammensetzung nach einem der vorangehenden Ansprüche.

13. Verfahren zur Herstellung einer Platin-Zusammensetzung mit den folgenden chronologischen Schritten:
A) Herstellen einer Schmelze aufweisend zumindest 70 Gew% Platin, bis zu 29,95 Gew% eines der Metalle Rhodium, Gold, Iridium und Palladium oder einer Mischung von wenigstens zwei der Metalle Rhodium, Gold, Iridium und Palladium, zwischen 0,05 Gew% und 1 Gew% oxidierbare Nicht-Edelmetalle in Form von Zirkonium, Yttrium und Scandium und als Rest Platin einschließlich Verunreinigungen, wobei das Verhältnis von Zirkonium zu Yttrium in der Schmelze in einem Bereich von 5,9:1 bis 4,3:1 liegt und das Verhältnis von Zirkonium zu Scandium in der Schmelze mindestens 17,5:1 beträgt,
B) Erstarren der Schmelze zu einem Festkörper,
C) Verarbeiten des Festkörpers zu einem Volumenkörper; und
D) Oxidation der in dem Volumenkörper enthaltenen Nicht-Edelmetalle durch eine Wärmebehandlung in oxidierendem Medium über einen Zeitraum von wenigstens 48 Stunden bei einer Temperatur von zumindest 750°C.

14. Verfahren nach Anspruch 13, **dadurch gekennzeichnet, dass** mit dem Verfahren eine Platin-Zusammensetzung nach einem der Ansprüche 1 bis 11 hergestellt wird.

15. Verfahren nach Anspruch 13 oder 14, **dadurch gekennzeichnet, dass** bei der Oxidation in Schritt D) der Sauerstoff durch den Festkörper diffundiert und durch Yttriumoxid und/oder Scandiumoxid kubisch stabilisiertes Zirkonoxid mittels Sauerstoffionenleitung transportiert wird und/oder bei der Oxidation in Schritt D) eine Dispersionshärtung durch aus der Metallmatrix des Festkörpers ausgeschiedene Yttriumoxid-stabilisierte und/oder Scandiumoxid-stabilisierte Zirkonoxid-Partikel erfolgt.

## Claims

1. A dispersion-hardened platinum composition comprising at least 70 wt.% platinum, the platinum composition containing up to 29.95 wt.% of one of the metals rhodium, gold, iridium and palladium or of a mixture of at least two of the metals rhodium, gold, iridium and palladium, the platinum composition containing between 0.05 wt.% and 1 wt.% oxides of the non-precious metals zirconium, yttrium and scandium, and the platinum composition containing, as the remainder, the platinum including impurities, wherein
between 8.0 mol.% and 10.0 mol.% of the oxides of the non-precious metals is yttrium oxide, between 0.1 mol.% and 5.0 mol.% of the oxides is scandium oxide, and the remainder of the oxides is zirconia, including oxide impurities.

2. The platinum composition according to Claim 1, **characterized in that** the oxides of the non-precious metals zirconium, yttrium and scandium are completely oxidized at least by 70%, preferably are oxidized at least by 90%, and particularly preferably are completely oxidized.

3. The platinum composition according to Claim 1 or 2, **characterized in that** the total proportion of impurities in the platinum composition is at most 1 wt.%, preferably at most 0.5 wt.%.

4. The platinum composition according to any one of the preceding claims, **characterized in that**
at least 50 mol.% of the oxides of the non-precious metals are cubic zirconia stabilized with yttrium oxide and/or scandium oxide, and preferably at least 80 mol.% of the oxides of the non-precious metals are cubic zirconia stabilized with yttrium oxide and/or scandium oxide.

5. The platinum composition according to any one of the preceding claims, **characterized in that**
the platinum composition is produced by melting metallurgy, is then rolled out and is oxidized by heat treatment in an oxidizing medium such that the non-precious metals contained in the platinum composition are completely oxidized.

6. The platinum composition according to any one of the preceding claims, **characterized in that**
the ratio of yttrium oxide to scandium oxide in the platinum composition is in a range of from 2.6:1 to 10:1.

7. The platinum composition according to any one of the preceding claims, **characterized in that**
between 8.0 mol.% and 10.0 mol.% of the oxides is yttrium oxide, preferably between 8.5 mol.% and 9.5 mol.% of the oxides is yttrium oxide.

8. The platinum composition according to any one of the preceding claims, **characterized in that**
between 1.0 mol.% and 3.0 mol.% of the oxides is scandium oxide, preferably between 1.5 mol.% and 2.5 mol.% of the oxides is scandium oxide.

9. The platinum composition according to any one of the preceding claims, **characterized in that**
the platinum composition contains at least 80 wt.% platinum including impurities, the platinum composition preferably containing up to 10 wt.% gold or up to 19.95 wt.% rhodium, and/or
the platinum composition contains at least 1 wt.% rhodium, gold, palladium or iridium, the platinum composition preferably containing at least 5 wt.% rhodium and/or at least 3 wt.% gold.

10. The platinum composition according to any one of the preceding claims, **characterized in that**
the platinum composition contains between 5 wt.% and 20 wt.% rhodium and no gold, iridium or palladium, except for impurities, or
the platinum composition contains between 2 wt.% and 10 wt.% gold and no rhodium, iridium or palladium, except for impurities,
preferably
the platinum composition consisting of 10 wt.% rhodium, the oxides of the non-precious metals zirconium, yttrium and scandium, and, as the remainder, platinum including impurities, or
the platinum composition consisting of 5 wt.% gold, the oxides of the non-precious metals zirconium, yttrium and scandium, and, as the remainder, platinum including impurities.

11. The platinum composition according to any one of the preceding claims, **characterized in that**
the platinum composition has a creep strength of at least 500 h at 1400°C under a load of 20 MPa.

12. A crucible for crystal growing, a semi-finished product, a tool, a tube, a stirrer, a fiberglass nozzle or a component for producing or processing glass consisting of or having a platinum composition according to any one of the preceding claims or a temperature sensor having a platinum composition according to any one of the preceding claims.

13. A method for producing a platinum composition comprising the following chronological steps:
A) producing a melt having at least 70 wt.% platinum, up to 29.95 wt.% of one of the metals rhodium, gold, iridium and palladium or of a mixture of at least two of the metals rhodium, gold, iridium and palladium, between 0.05 wt.% and 1 wt.% oxidizable non-precious metals in the form of zirconium, yttrium and scandium, and, as the remainder, platinum including impurities, wherein the ratio of zirconium to yttrium in the melt is in a range of from 5.9:1 to 4.3:1 and the ratio of zirconium to scandium in the melt is at least 17.5:1,
B) hardening the melt to form a solid body,
C) processing the solid body to form a volume body; and
D) oxidizing the non-precious metals contained in the volume body by a heat treatment in an oxidizing medium over a time period of at least 48 hours at a temperature of at least 750°C.

14. The method according to Claim 13, **characterized in that** a platinum composition according to any one of Claims 1 to 11 is produced using the method.

15. The method according to Claim 13 or 14, **characterized in that** during the oxidation in step D), the oxygen is diffused through the solid body and cubic zirconia stabilized by yttrium oxide and/or scandium oxide is transported by means of oxygen ion conduction and/or
during the oxidation in step D), dispersion hardening is carried out by yttriumoxide-stabilized and/or scandium-oxide-stabilized zirconia particles precipitated from the metal matrix of the solid body.

## Revendications

1. Composition de platine à durcissement par phase dispersée comprenant au moins 70 % en poids de platine, la composition de platine jusqu'à 29,95 % en poids d'un des métaux rhodium, or, iridium et palladium ou d'un mélange d'au moins deux des métaux rhodium, or, iridium et palladium, la composition de platine contenant entre 0,05 % en poids et 1 % en poids d'oxydes des métaux non précieux zirconium, yttrium et scandium, et la composition de platine contenant comme reste du platine, y compris des impuretés, entre 8,0 % en mole et 10,0 % en mole des oxydes des métaux non précieux étant de l'oxyde d'yttrium, entre 0,1 % en mole et 5,0 % en mole étant de l'oxyde de scandium et le reste des oxydes étant de l'oxyde de zirconium, y compris des impuretés d'oxydes.

2. Composition de platine selon la revendication 1, **caractérisée en ce que** les oxydes des métaux non précieux zirconium, yttrium et scandium sont présents au moins à 70 % complètement oxydés, sont présents de préférence au moins à 90 % oxydés et sont présents encore plus préférablement totalement oxydés.

3. Composition de platine selon la revendication 1 ou 2, **caractérisée en ce que** la somme des impuretés représente une proportion de maximum 1 % en poids dans la composition de platine, de préférence de maximum 0,5 % en poids.

4. Composition de platine selon l'une quelconque des revendications précédentes, **caractérisée en ce que**
les oxydes de métaux non précieux sont présents au moins à 50 % en mole comme un oxyde de zirconium cubique stabilisé avec un oxyde d'yttrium et/ou un oxyde de scandium, les oxydes des métaux non précieux sont présents de préférence au moins à 80 % en mole comme un oxyde de zirconium cubique stabilisé avec un oxyde d'yttrium et/ou un oxyde de scandium.

5. Composition de platine selon l'une quelconque des revendications précédentes, **caractérisée en ce que**
la composition de platine est produite par métallurgie de fusion, puis laminée et oxydée par un traitement thermique dans un milieu oxydant, de telle sorte que les métaux non précieux contenus dans la composition de platine soient totalement oxydés.

6. Composition de platine selon l'une quelconque des revendications précédentes, **caractérisée en ce que**
le rapport d'oxyde d'yttrium à oxyde de scandium dans la composition de platine se situe dans la plage de 2,6:1 à 10:1.

7. Composition de platine selon l'une quelconque des revendications précédentes, **caractérisée en ce que**
entre 8,0 % en mole et 10,0 % en mole des oxydes est de l'oxyde d'yttrium, de préférence entre 8,5 % en mole et 9,5 % en mole des oxydes est de l'oxyde d'yttrium.

8. Composition de platine selon l'une quelconque des revendications précédentes, **caractérisée en ce que**
entre 1,0 % en mole et 3,0 % en mole des oxydes est de l'oxyde de scandium, de préférence entre 1,5 % en mole et 2,5 % en mole des oxydes est de l'oxyde de scandium.

9. Composition de platine selon l'une quelconque des revendications précédentes, **caractérisée en ce que**
la composition de platine contient au moins 80 % en poids de platine, y compris des impuretés, la composition de platine contenant de préférence jusqu'à 10 % en poids d'or ou jusqu'à 19,95 % en poids de rhodium, et/ou
la composition de platine contient au moins 1 % en poids de rhodium, d'or, de palladium ou d'iridium, la composition de platine contenant de préférence au moins 5 % en poids de rhodium et/ou au moins 3 % en poids d'or.

10. Composition de platine selon l'une quelconque des revendications précédentes, **caractérisée en ce que**
la composition de platine contient entre 5 % en poids et 20 % en poids de rhodium et pas d'or, d'iridium ou de palladium à l'exception d'impuretés, ou
la composition de platine contient entre 2 % en poids et 10 % en poids d'or et pas de rhodium, d'iridium ou de palladium à l'exception d'impuretés,
de préférence
la composition de platine étant composée de 10 % en poids de rhodium, des oxydes des métaux non précieux zirconium, yttrium et scandium et le reste étant du platine, y compris des impuretés, ou
la composition de platine étant composée de 5 % en poids d'or, des oxydes des métaux non précieux zirconium, yttrium et scandium et le reste étant du platine, y compris des impuretés.

11. Composition de platine selon l'une quelconque des revendications précédentes, **caractérisée en ce que**
la composition de platine présente une résistance de fluage d'au moins 500 h à 1 400 °C sous une charge de 20 MPa.

12. Creuset pour la cristallerie, demi-produit, outil, tuyau, agitateur, douille à fibres de verre ou composant pour la fabrication ou le traitement de verre composé de ou présentant une composition de platine selon l'une quelconque des revendications précédentes ou capteur de température présentant une composition de platine selon l'une quelconque des revendications précédentes.

13. Procédé pour la production d'une composition de platine comprenant les étapes chronologiques suivantes :
A) production d'une masse fondue présentant au moins 70 % en poids de platine, jusqu'à 29,95 % en poids d'un des métaux rhodium, or, iridium et palladium ou un mélange d'au moins deux des métaux rhodium, or, iridium et palladium, entre 0,05 % en poids et 1 % en poids de métaux non précieux oxydables sous la forme de zirconium, d'yttrium et de scandium, le reste étant du platine, y compris des impuretés, le rapport de zirconium à yttrium dans la masse fondue se situant dans la plage de 5,9:1 à 4,3:1 et le rapport de zirconium à scandium dans la masse fondue étant au moins de 17,5:1,
B) solidification de la masse fondue en un corps solide,
C) traitement du corps solide en un corps volumique, et
D) oxydation des métaux non précieux contenus dans le corps volumique par un traitement thermique dans un milieu oxydant pendant une période de temps d'au moins 48 heures à une température d'au moins 750 °C.

14. Procédé selon la revendication 13, **caractérisé en ce qu'**
une composition de platine selon l'une quelconque des revendications 1 à 11 est produite à l'aide du procédé.

15. Procédé selon la revendication 13 ou 14, **caractérisé en ce que,**
lors de l'oxydation dans l'étape D), l'oxygène diffuse à travers le corps solide et de l'oxyde de zirconium cubique stabilisé à l'oxyde d'yttrium et/ou à l'oxyde de scandium est transporté au moyen d'une conduite d'ions d'oxygène, et/ou lors de l'oxydation dans l'étape D), un durcissement par dispersion est effectué par des particules d'oxyde de zirconium stabilisées à l'oxyde d'yttrium et/ou stabilisées à l'oxyde de scandium, séparées de la matrice métallique du corps solide.
